# EUROPÄISCHE PATENTANMELDUNG

(11) **EP 1 755 135 A2**
(43) Veröffentlichungstag der Anmeldung: **21.02.2007**
(21) Anmeldenummer: 06015569.4
(22) Anmeldetag: 26.07.2006
(51) Int. Cl.: H01H 71/04, G01R 31/327, H01H 9/16, H01H 71/02

(54) **Schaltungsanordnung zur Erfassung und Auswertung elektrischer und physikalischer Messgrössen in einem elektrischen Schaltgerät**

(30) Priorität: 19.08.2005 DE 102005039573
(71) Anmelder: ABB PATENT GmbH, 68526 Ladenburg (DE)
(72) Erfinder: Zank, Gunnar, Dipl.-Ing., 06179 Teutschenthal (DE)
(74) Vertreter: Miller, Toivo

(57) **Zusammenfassung**

Die Erfindung bezieht sich auf eine Schaltungsanordnung zur Erfassung und Auswertung elektrischer und/oder physikalischer Messgrößen, insbesondere zur Strom-, Spannungs- und/oder Kontakttemperaturmessung, mit jeweils einem in den Phasenleitern (L1, L2, L3) eines elektrischen Schaltgerätes (1), insbesondere eines Schütz, angeordneten Messmoduls (11), welches aus einem Messschaltkreis zur Erfassung und Auswertung elektrischer und/oder physikalischer Messgrößen, insbesondere eines Stromes, einer Spannung und/oder einer Temperatur, aufgebaut ist und der Messschaltkreis mit einer seriellen Schnittstelle zusammenwirkt. Die serielle Schnittstelle ist mit einer Auswerteeinheit (12) verbunden, welcher die vom Messschaltkreis ermittelten elektrischen und/oder physikalischen Messgrößen, wie beispielsweise der ermittelte Strom, die ermittelten Spannung und/oder die ermittelte Temperatur, über die serielle Schnittstelle zur weiteren Verarbeitung zuführbar sind. Die Auswerteeinheit (12) stellt die jeweiligen Informationen an einer Busschnittstelle (14) bereit. Die Auswerteeinheit (12) und die Busschnittstelle (14) sind direkt im Schaltgerät (1) angeordnet.

## Beschreibung

Die Erfindung betrifft eine Schaltungsanordnung zur Erfassung und Auswertung elektrischer und physikalischer Messgrößen in einem elektrischen Schaltgerät mit Feldbusschnittstelle, insbesondere zur Strom-, Spannungs- und Kontakttemperaturmessung in einem Schütz, gemäß dem Oberbegriff des Anspruchs 1.

Bei elektrischen Schaltgeräten, wie beispielsweise einem Schütz, Schalter,
Leistungsschalter oder auch Leistungsschutzschalter, wie sie auch in der
Niederspannungschaltgerätetechnik Verwendung finden, wird durch Ansteuerung einer elektromagnetischen Steuerspule, mit Hilfe einer Steuerspannung, ein Öffnen und Schließen von Kontakten bewirkt. Dadurch wird ein Stromkreis geschlossen und ein elektrischer Verbraucher, wie beispielsweise ein Motor, gesteuert.

In elektrotechnischen Anwendungen werden Schütze und andere elektrische Schaltgräte meist zusammen mit externen Strom- und Spannungswandlern eingebaut, um zusätzliche Informationen, beispielsweise hinsichtlich Spannungs- und Stromwerte, zu erfassen. Diese Informationen werden einem zusätzlichen elektronischen Gerät zugeführt, welches Daten zur Weiterleitung über eine Busschnittstelle aufbereitet.

Weiterhin werden Temperaturmessfühler eingesetzt, um Temperaturen der elektrischen Komponenten, beispielsweise an den Kontakten des Schützes, zu erfassen. Die mittels der Temperaturmessfühler ermittelten Kontakttemperaturen müssen ebenfalls einem zusätzlichen Auswertegerät zugeführt werden, das wiederum Informationen über die gemessenen Temperaturen über eine zusätzliche Busschnittstelle zur weiteren Verarbeitung zur Verfügung stellt.

Die zur Strom- und Spannungsmessung erforderlichen externen Strom- und Spannungswandler und die Temperaturmessfühler sowie die für die Aufbereitung der gemessenen Strom- und Spannungswerte und der ermittelten Kontakttemperaturen erforderlichen externen Auswertegeräte, welche die Informationen der Strom-, Spannungs- und Temperaturmessung für die Busschnittstelle aufbereiten, bedingen hohe Gerätekosten und einen hohen fehleranfälligen Verdrahtungsaufwand. Auch sind Messfehler nicht auszuschließen, die durch Stromverluste in den Leitungen zur Verbindung der Temperaturmessfühler und der Strom- und Spannungswandler mit den zusätzlichen Auswertegeräten zur Anpassung der Informationen an die Busschnittstelle bedingt sind.

Ein weiterer Nachteil bekannter Schaltungsanordnungen zur Strom-, Spannungs- und Kontakttemperaturmessung in einem elektrischen Schaltgerät ist darin zu sehen, dass alle Geräte über ihre eigene Busschnittstelle, auch Kommunikationsschnittstelle genannt, in ein nachfolgendes Verarbeitungssystem einzubinden sind.

Ausgehend von den angegebenen Nachteilen liegt der Erfindung demgemäß die Aufgabe zugrunde, die vorgenannten Nachteile zu vermeiden, und insbesondere den Montageaufwand, den Platzbedarf und die Gerätekosten bei der Installation eines elektrischen Schaltgerätes, insbesondere eines Schützes, zu reduzieren.

Diese Aufgabe wird erfindungsgemäß durch eine Schaltungsanordnung der eingangs genannten Art mit den im Anspruch 1 angegebenen Merkmalen gelöst. Vorteilhafte Ausgestaltungen und Verbesserungen der erfindungsgemäßen Schaltungsanordnung sind in weiteren Ansprüchen und in der Beschreibung angegeben.

Erfindungsgemäß umfasst die Schaltungsanordnung zur Erfassung und Auswertung elektrischer sowie physikalischer Messgrößen in einem elektrischen Schaltgerät, insbesondere zur Strom-, Spannungs- und Kontakttemperaturmessung in beispielsweise einem Schütz, jeweils ein in den Phasenleitern eines elektrischen oder elektronischen Schaltgerätes, insbesondere eines Schütz, angeordnetes Messmodul, welches einen Messschaltkreis zur Ermittlung elektrischer und physikalischer Messgrößen, insbesondere eines Stromes, einer Spannung und/oder einer Temperatur, aufweist. Der Messschaltkreis wirkt über eine serielle Schnittstelle mit einer Auswerteeinheit zusammen. Der Auswerteeinheit, welche vorzugsweise als Mikroprozessor oder Mikrocomputer ausgeführt ist, wird die vom Messschaltkreis ermittelte jeweilige elektrische und/oder physikalische Messgröße, insbesondere die ermittelte Stromstärke, die ermittelte Spannung und/oder die ermittelte Temperatur, über die serielle Schnittstelle zur weiteren Verarbeitung übertragen. Die Auswerteeinheit stellt Informationen über die ermittelten elektrischen und/oder physikalischen Messgrößen an einer Busschnittstelle bereit. Die Auswerteeinheit und die Busschnittstelle sind, wie auch das Messmodul direkt im Schaltgerät, insbesondere einem Schütz, angeordnet.

Somit können in vorteilhafter Weise externe Temperaturmessfühler und/oder Strom- und/oder Spannungswandler entfallen. Auch sind mit der erfindungsgemäßen Schaltungsanordnung zusätzliche externe Auswerteeinheiten und Busschnittstellen für die Bereitstellung der Informationen über die ermittelten elektrischen und/oder physikalischen Messgrößen, insbesondere den gemessenen Strom, die gemessene Spannung und/oder die gemessene Kontakttemperatur, an ein nachgeführtes oder nachgeschaltetes Verarbeitungssystem nicht mehr notwendig.

In einer vorteilhaften Ausführungsform der Erfindung sind Informationen über die elektrischen und/oder physikalischen Messgrößen, insbesondere die gemessene Stromstärke, die gemessene Spannung und/oder die gemessene Kontakttemperatur, über die als Feldbusschnittstelle ausgeführte Busschnittstelle und einen als Feldbus ausgeführten Bus an das Verarbeitungssystem übertragbar.

In einer vorteilhaften Ausgestaltung der Schaltungsanordnung ist das Messmodul jeweils in den Phasenleitern des elektrischen Schaltgerätes, insbesondere des Schütz angeordnet. Bei einem Schütz ist der jeweilige Phasenleiter aus zwei Leiterabschnitten gebildet, zwischen denen ein elektrisches Widerstandselement, im folgenden auch Shunt genannt, aus einem Material mit gegenüber dem Material des Phasenleiters höherem elektrischem Widerstand vorgesehen ist. Im Bereich des Widerstandselementes ist eine Abflachung mit einer Vertiefung angeordnet, über die brückenartig das Messmodul gelegt ist und durch die ein Teil des den Leiter durchfließenden Stromes fließt. Das Messmodul ist nahe einem Verbindungskontaktstück angeordnet, mit dem der Leiter mit einem weiteren Leiter in elektrisch leitende Verbindung bringbar ist, so dass die an der Kontaktstelle entstehende Wärme gemessen wird.

Eine vorteilhafte Ausführung des Messmoduls beruht auf einem aus dem Automobilbereich im Batteriemanagement 12V/24V verwendeten ASIC (applicationspecific integrated circuit)- Schaltkreis IHM-A-1500 der Firma Isabellenhütte zur Strommessung, der sich durch hohe Empfindlichkeit auszeichnet.

Dieser Schaltkreis kann verwendet werden zur Strom-, Spannungs- und Temperaturmessung in dem Leiterabschnitt, der mit dem oben genannten Kontaktstück unmittelbar in Verbindung steht oder dieses trägt, so dass dort entstehende Wärme direkt von dem Schaltkreis gemessen werden kann.

Als Phasenleiter eines elektrischen Schaltgerätes, insbesondere eines Schützes, kann entweder ein Flachbandleiter verwendet werden, der zwei Abschnitte aufweist, zwischen denen sich das elektrische Widerstandselement befindet; oder ein Runddrahtleiter verwendet werden, der mit einer Abflachung versehen ist, in deren Bereich sich die Vertiefung und damit auch das Widerstandselement befinden.

Der Strom fließt dabei über das Widerstandselement und parallel dazu über den Messschaltkreis.

Dabei kann das Widerstandselement aus Manganin hergestellt sein, welches gegenüber Kupfer einen um 20-fach erhöhten Widerstand aufweist.

In einer Ausgestaltung der Erfindung ist weiterhin vorgesehen, dass jeweils ein Messmodul in den Eingangs- und Ausgangsleitern des elektrischen Schaltgerätes, insbesondere des Schützes, angeordnet ist.

Mit der erfindungsgemäßen Schaltungsanordnung sind die an der Busschnittstelle der Auswerteinheit bzw. Auswerteeinheit bereitstehenden Informationen über den gemessenen Strom, die gemessene Spannung und/oder die gemessenen Temperatur in vorteilhafter Weise für eine Leistungsberechnung und/oder für Wartungsinformationen verwendbar, wobei die Wartungsinformationen beispielsweise die Belastung der Kontakte des elektronischen Schaltgerätes, insbesondere des Schützes, die Beschaffenheit oder der Zustand der Kontakte, auch als Kontaktqualität bezeichnen, und/ oder die Anzahl der Schaltausführungen bzw. Schaltvorgänge und/oder die Strombelastung betreffen.

Anhand des in der folgenden Figur dargestellten Ausführungsbeispieles sollen die Erfindung sowie weitere vorteilhafte Ausgestaltungen, Verbesserungen und weitere Vorteile der Erfindung näher erläutert und beschrieben werden.

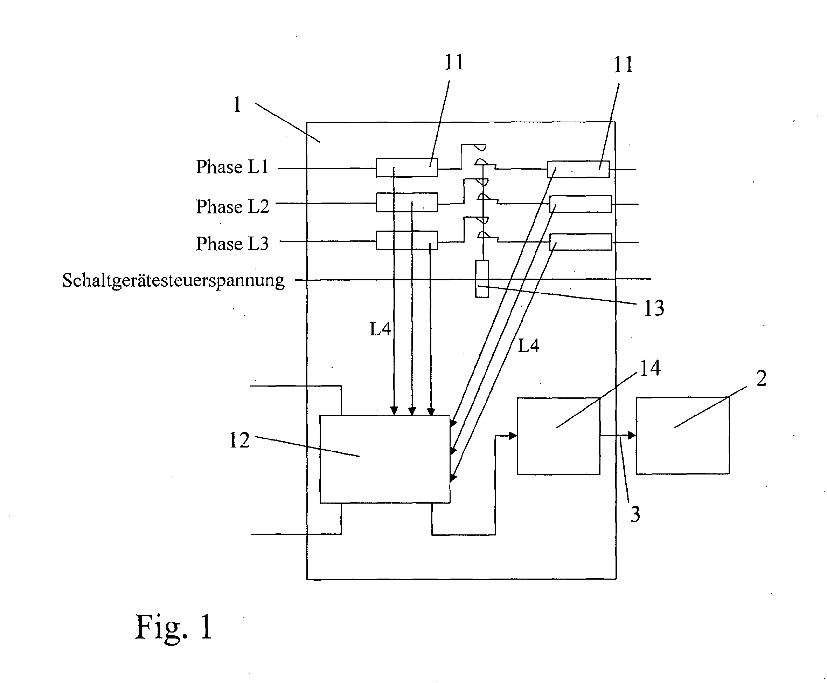

Fig. 1 zeigt eine Ausführungsform der erfindungsgemäßen Schaltungsanordnung zur Erfassung und Auswertung elektrischer und physikalischer Messgrößen in einem elektrischen Schaltgerät, wobei hier beispielhaft eine Schaltungsanordnung zur Strom-, Spannungs- und Kontakttemperaturmessung an den Phasenleitern L1, L2, L3 eines Schaltgerätes 1, insbesondere eines Schützes angegeben ist und wobei das Schaltgerät 1 eine Feldbusschnittstelle 14 zum Anschluss des Schaltgerätes 1 an einen Feldbus 3 aufweist.

Das Schaltgerät 1 umfasst eine Steuerspule 13, die mittels externer Ansteuerung über die Steuerspannung ein Öffnen und Schließen von Kontakten bewirkt.

In den Phasenleitern L1, L2, L3 des Schaltgerätes 1 ist jeweils ein Messmodul 11 angeordnet, welches einen Messschaltkreis zur Ermittlung der Stromstärke, der Spannung und der Kontakttemperatur und eine serielle Schnittstelle aufweist. Die serielle Schnittstelle des jeweiligen Messmoduls 11 ist über eine Leitung L4 mit einer Auswerteeinheit 12 verbunden, welcher die vom Messschaltkreis ermittelte Stromstärke, die ermittelten Spannung und/oder die ermittelten Temperatur über die serielle Schnittstelle zur weiteren Verarbeitung zugeführt wird. Die Auswerteeinheit 12 bereitet die Strom-, Spannungs- und Temperaturmesswerte zur Übertragung an die Busschnittstelle auf und überträgt die so aufbereiteten Informationen über den ermittelten Strom, die ermittelte Spannung und die ermittelte Temperatur zur Busschnittstelle 14.

Eine Aufbereitung der Strom-, Spannungs- oder Temperaturmesswerte, aber auch allgemein der elektrischen und/oder physikalischer Messgrößen, kann dabei beispielsweise eine Umwandlung analoger Messsignale in digitale Daten und/oder Informationen, die zudem noch zeitabhängig erfassbar sind, und/oder eine Vorverarbeitung der analogen Messsignale, beispielsweise durch Filtern, Verstärken und/oder Vergleichen, insbesondere mit vorbestimmten Signal- oder Messwerten, und/oder eine Vorverarbeitung der digitalen Daten und/oder Informationen umfassen. Demgemäß können die aufbereiteten Informationen vorteilhaft bereits Informationen hinsichtlich der Signal- oder Messgrößenqualität bzw. ― güte, stochastische Informationen hinsichtlich der erfassten Messgrößen, wie beispielsweise Tendenzen, zeitliche Entwicklungen und/oder Prognosen über mögliche Entwicklungen oder Verläufe umfassen. Im Rahmen der Aufbereitung ist vorteilhaft auch ein Vergleich mit vorbestimmten Grenz- und/oder Schwellenwerten, beispielsweise um Sicherheitsaspekten zu genügen und/oder um entsprechende Warn- und/oder Hinweis- und/oder Schaltsignale zu geben oder auszulösen, vorsehbar.

Das Messmodul 11 ist aus einem Widerstandselement, auch Shunt genannt, und einem als ASIC ausgeführten Schaltkreis aufgebaut. Das Messmodul 11 ist jeweils zur Strom-, Spannungs- und/oder Temperaturmessung in einem Leiterabschnitt des Phasenleiters L1, L2. L3 vorgesehen. Vorzugsweise sind der Shunt und der Schaltkreis in den Eingangsphasenleitern und Ausgangsphasenleitern integriert.

Der Schaltkreis ist aus vorzugsweise vier Messkanälen, einem integrierten Temperatursensor und der seriellen Schnittstelle zum Anschluss des Schaltkreises an die Auswerteeinheit 12 aufgebaut.

Die Strommessung wird mittels dem direkt in einem als Strompfad ausgeführten Messkanal über den integrierten Shunt und die Spannungsmessung wird über im Schaltkreis integrierte hochohmige Vorwiderstände eines weiteren Messkanals des Schaltkreises ausgeführt.

Die Messung der Kontakttemperatur wird mit einem direkt im Schaltkreis integrierten Temperatursensor ausgeführt, ist direkt zur Auswerteeinheit 12 übertragbar und von der Auswerteeinheit 12 direkt auswertbar.

In einer vorteilhaften Ausführungsform der Erfindung sind die Informationen über die elektrischen und/oder physikalischen Messgrößen, insbesondere den gemessenen Strom, die gemessene Spannung und/oder die gemessene Kontakttemperatur, über die Feldbusschnittstelle 14 und den Feldbus 3 an ein Verarbeitungssystem 2, insbesondere zur Leistungsberechnung und/oder Auswertung der Information für die Wartung, insbesondere zur Planung und Durchführung von Instandhaltungs- und Wartungsmaßnahmen, übertragbar.

## Patentansprüche

1. Schaltungsanordnung zur Erfassung und Auswertung elektrischer und/oder physikalischer Messgrößen, insbesondere zur Strom-, Spannungs- und/oder Kontakttemperaturmessung, mit jeweils einem in den Phasenleitern (L1, L2, L3) eines Schaltgerätes (1) angeordneten Messmodul (11), welches einen Messschaltkreis zur Erfassung und Auswertung elektrischer und/oder physikalischer Messgrößen, insbesondere eines Stromes, einer Spannung und/oder einer Temperatur, aufweist und welcher Messschaltkreis mit einer seriellen Schnittstelle zusammenwirkt, **dadurch gekennzeichnet, dass**
- die serielle Schnittstelle mit einer Auswerteeinheit (12) verbunden ist, welcher die vom Messschaltkreis ermittelten elektrischen und/oder physikalischen Messgrößen, insbesondere Stromstärke, die ermittelten Spannung und/oder die ermittelte Temperatur, über die serielle Schnittstelle zur weiteren Verarbeitung zuführbar sind,
- die Auswerteeinheit (12) Informationen über die ermittelten elektrischen und/oder physikalischen Messgrößen an einer Busschnittstelle (14) bereitstellt, und
- die Auswerteeinheit (12) und die Busschnittstelle (14) direkt im Schaltgerät (1) angeordnet sind.

2. Schaltungsanordnung nach Anspruch 1, **dadurch gekennzeichnet, dass** das Messmodul (11) ein Widerstandselement und einen Schaltkreis aufweist, welche zur Erfassung und Auswertung elektrischer und/oder physikalischer Messgrößen, insbesondere zur Messung von Stromstärke, elektrischer Spannung und/oder Temperatur, in einem Leiterabschnitt des Phasenleiters (L1, L2, L3) vorgesehen sind.

3. Schaltungsanordnung nach einem der Ansprüche 1 oder 2, **dadurch gekennzeichnet, dass** es sich bei dem Schaltgerät (1) um ein Schütz handelt.

4. Schaltungsanordnung nach einem der vorherigen Ansprüche, **dadurch gekennzeichnet, dass** der Schaltkreis ein ASIC ist.

5. Schaltungsanordnung nach einem der vorherigen Ansprüche, **dadurch gekennzeichnet, dass** im Schaltgerät (1) in die Leiterbahnen der Phasenleiter (L1, L2, L3) jeweils ein Widerstandselement und ein ASIC- Schaltkreis integriert sind.

6. Schaltungsanordnung nach einem der vorherigen Ansprüche, **dadurch gekennzeichnet, dass** der Messschaltkreis wenigstens vier Messkanäle und/oder einen integrierten Temperatursensor aufweist.

7. Schaltungsanordnung nach einem der Ansprüche 2 bis 6, **dadurch gekennzeichnet, dass** eine Strommessung mittels dem direkt in einem als Strompfad ausgeführten Messkanal integrierten Widerstandselement durchführbar ist.

8. Schaltungsanordnung nach Anspruch 6 oder 7, **dadurch gekennzeichnet, dass** in einem weiteren Messkanal des Schaltkreises mehrere zur Spannungsmessung integrierte hochohmige Vorwiderstände vorgesehen sind.

9. Schaltungsanordnung nach einem der vorherigen Ansprüche, **dadurch gekennzeichnet, dass** die Messung der Temperatur mit einem direkt im Schaltkreis integrierten Temperatursensor ausführbar ist und direkt zur Auswerteeinheit (12) übertragbar und auswertbar ist.

10. Schaltungsanordnung nach einem der vorherigen Ansprüche, **dadurch gekennzeichnet, dass** die Auswerteeinheit (12) ein Mikroprozessor und/oder Mikrocomputer ist.

11. Schaltungsanordnung nach einem der vorherigen Ansprüche, **dadurch gekennzeichnet, dass** die von der Auswerteeinheit (12) ermittelten Informationen, insbesondere über den gemessenen Strom, die gemessene Spannung und/oder die gemessene Temperatur, über die Busschnittstelle (14) und einen Feldbus (3) an ein Verarbeitungssystem (2) übertragbär sind.

12. Schaltungsanordnung nach einem der vorherigen Ansprüche, **dadurch gekennzeichnet, dass** die an der Auswerteeinheit bereitstehenden Informationen über die elektrischen und/oder physikalischen Messgrößen, insbesondere den gemessenen Strom, die gemessene Spannung und/oder die gemessenen Temperatur, für eine Leistungsberechnung und/oder für Wartungsinformationen verwendbar sind.

13. Schaltungsanordnung nach Anspruch 13 Ansprüche, **dadurch gekennzeichnet, dass** die Wartungsinformationen die Belastung der Kontakte des Schaltgerätes (1), insbesondere des Schützes" die Beschaffenheit der Kontakte, die Kontaktqualität und/ oder Anzahl der Schaltausführungen und/oder die Strombelastung betreffen .

14. Schaltungsanordnung nach einem der vorherigen Ansprüche, **dadurch gekennzeichnet, dass** jeweils ein Messmodul (11) in den Eingangs- und Ausgangsleitern des Schaltgerätes, insbesondere des Schützes (1) angeordnet ist.
